# EUROPÄISCHE PATENTSCHRIFT

(11) **EP 2 996 449 B1**
(45) Veröffentlichungstag und Bekanntmachung des Hinweises auf die Patenterteilung: **29.11.2017**
(21) Anmeldenummer: 14184362.3
(22) Anmeldetag: 11.09.2014
(51) Int. Cl.: H05K 7/14

(54) **Stromrichteranordnung mit einem mehrphasigen Stromrichter**
Frequency converter assembly with a multiphase frequency converter
Système de convertisseur de courant doté d'un convertisseur multiphases

(43) Veröffentlichungstag der Anmeldung: 16.03.2016
(73) Patentinhaber: Siemens Aktiengesellschaft, 80333 München (DE)
(72) Erfinder: Hetzel, Brigitte, 90587 Obermichelbach (DE); Hiller, Marc, 91207 Lauf an der Pegnitz (DE); Pfauser, Anton, 96178 Pommersfelden (DE); Popp, Gudrun, 91054 Buckenhof (DE); Schickert, Elfriede, 91093 Hessdorf (DE)

(56) Entgegenhaltungen:
- DE-A1-102011 001 786
- DE-A1-102011 006 987
- US-A1- 2007 046 252
- US-A1- 2010 321 896
- US-A1- 2012 327 602

## Beschreibung

Die Erfindung betrifft eine Stromrichteranordnung mit einem mehrphasigen Stromrichter, der für jede Stromrichterphase mehrere elektrisch miteinander verschaltete Stromrichtermodule umfasst.

Modular aufgebaute Stromrichter werden häufig in Stromrichterschränken angeordnet. Bei einer Beschädigung eines Stromrichtermoduls, beispielsweise im Falle eines Kurzschlusses in einem Stromrichtermodul, werden häufig auch andere Stromrichtermodule oder sogar der gesamte Innenraum des Stromrichterschranks verschmutzt oder beschädigt, so dass der Stromrichterschrank zeit- und kostenaufwändig gereinigt und/oder Stromrichtermodule oder deren Verschienungen ausgewechselt werden müssen.

DE 10 2011 006 987 A1 offenbart ein modulares Stromrichterschranksystem eines Stromrichters mit wenigstens einem ein oberes und ein unteres Stromrichterventil aufweisenden Phasenmodul.

DE 10 2011 001 786 A1 offenbart eine Schaltschrankanordnung einer Vorrichtung zur Erzeugung elektrischer Energie, wobei die Schaltschrankanordnung mindestens zwei separate Leistungsschaltschränke aufweist.

Der Erfindung liegt die Aufgabe zugrunde, eine insbesondere hinsichtlich des Platzbedarfs und Wartungs- und Reparaturaufwands verbesserte Stromrichteranordnung anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Eine erfindungsgemäße Stromrichteranordnung umfasst einen mehrphasigen Stromrichter, der für jede Stromrichterphase mehrere elektrisch miteinander verschaltete Stromrichtermodule umfasst, und einen Stromrichterschrank, in dem der Stromrichter angeordnet ist. Jedes Stromrichtermodul weist einen Kühlkörper und wenigstens ein an dem Kühlkörper angeordnetes Halbleiterbauelement auf. Die Stromrichtermodule sind derart in dem Stromrichterschrank angeordnet, dass die Stromrichtermodule jeder Stromrichterphase eine Modulzeile horizontal hintereinander angeordneter Stromrichtermodule bilden und die Modulzeilen der verschiedenen Stromrichterphasen vertikal übereinander angeordnet sind.

Die Anordnung der Stromrichtermodule in übereinander angeordneten Modulzeilen ermöglicht eine platzsparende Anordnung der Stromrichtermodule. Auf diese Weise können mehr Stromrichtermodule in einem Stromrichterschrank vorgegebener Größe angeordnet werden bzw. für eine vorgegebene Anzahl von Stromrichtermodulen wird ein kleinerer und damit leichterer Stromrichterschrank benötigt als bei herkömmlichen Anordnungen. Diese Platz- und Gewichtsersparnis wirkt sich besonders vorteilhaft beispielsweise bei der Verwendung der Stromrichteranordnung auf einem Schiff oder in ähnlich platz- oder gewichtsbeschränkenden Umgebungen aus. Außerdem ermöglicht die Zuordnung der einzelnen Modulzeilen zu jeweils einer Stromrichterphase eine vereinfachte Verschienung des Stromrichters zur elektrischen Verschaltung der Stromrichtermodule, auf die unten noch näher eingegangen wird.

Eine Ausgestaltung der Erfindung sieht vor, dass wenigstens ein Stromrichtermodul in einer Stromrichterzelle gekapselt ist. Vorzugsweise weist dabei wenigstens eine Stromrichterzelle ein Zellengehäuse aus einem Polycarbonat oder Polymethylmethacrylat auf.

Die Kapselung von Stromrichtermodulen in einzelnen Stromrichterzellen ermöglicht vorteilhaft, Auswirkungen von Beschädigungen einzelner Stromrichtermodule, insbesondere durch Kurzschlüsse, lokal zu begrenzen, so dass sich derartige Beschädigungen nicht auf benachbarte Stromrichtermodule auswirken. Dadurch wird vorteilhaft der Wartungs- und Reparaturaufwand für die Stromrichteranordnung reduziert. Die Ausbildung von Stromrichterzellen mit Zellengehäusen aus einem Polycarbonat oder Polymethylmethacrylat ist dabei besonders vorteilhaft, da derartige Zellengehäuse die Stromrichtermodule besonders gut gegeneinander abschirmen.

Weitere Ausgestaltungen der Erfindung sehen vor, dass die Modulzeilen mit einer vertikal verlaufenden Zwischenkreisverschienung elektrisch verbunden sind und/oder die Stromrichtermodule jeder Modulzeile mit einer horizontal verlaufenden Phasenverschienung elektrisch verbunden sind.

Diese Ausgestaltungen der Erfindung nutzen vorteilhaft aus, dass die Stromrichtermodule einer Modulzeile jeweils einer Stromrichterphase zugeordnet sind. Dadurch genügt eine vertikal verlaufende Zwischenkreisverschienung zur elektrischen Verbindung der Stromrichterphasen und eine horizontal verlaufende Phasenverschienung für jede Stromrichterphase.

Eine weitere Ausgestaltung der Erfindung sieht vor, dass die Halbleiterbauelemente der Stromrichtermodule jeweils als ein Bipolartransistor mit isolierter Gate-Elektrode oder als eine Diode ausgebildet sind.

Ein Bipolartransistor (IGBT = Insulated-Gate Bipolar Transistor) mit isolierter Gate-Elektrode eignet sich aufgrund seines guten Durchlassverhaltens, seiner hohen Sperrspannung, Robustheit und leistungslosen Ansteuerung besonders vorteilhaft als Halbleiterbauelement für Stromrichtermodule. Jedoch brauchen nicht alle Halbleiterbauelemente der Stromrichtermodule als ein IGBT ausgebildet sein. Einige Stromrichtermodule können auch anstelle von IGBT wesentlich kostengünstigere Dioden aufweisen. Entsprechende Schaltungen werden in den unten beschriebenen Ausführungsbeispielen erläutert.

Spezielle Ausgestaltungen der Erfindung sehen wenigstens ein erstes Stromrichtermodul mit genau zwei elektrisch parallel oder in Reihe zueinander geschalteten ersten Halbleiterbauelementen, die jeweils als ein IGBT ausgebildet sind, und genau einer Ansteuerbaugruppe, über diese beiden Halbleiterbauelemente ansteuerbar sind, vor.

Diese Ausgestaltungen sind vorteilhaft, da beide IGBT durch eine gemeinsame Ansteuerbaugruppe ansteuerbar sind, so dass für ein derartiges Stromrichtermodul auch nur eine Ansteuerbaugruppe benötigt wird. Herkömmliche Stromrichtermodule weisen dagegen für jeden IGBT eine separate Ansteuerbaugruppe vor.

Eine weitere Ausgestaltung der Erfindung sieht vor, dass jede Modulzeile genau drei, vier oder fünf Stromrichtermodule aufweist.

Drei Stromrichtermodule sind in der Regel im Spannungsbereich zwischen etwa 2,3 kV und etwa 3,3 kV ausreichend, vier oder fünf Stromrichtermodule werden in der Regel im Spannungsbereich zwischen etwa 3,3 kV und etwa 7,2 kV benötigt.

Weitere Ausgestaltungen der Erfindung sehen einen mit den Modulzeilen elektrisch verbundenen und in dem Stromrichterschrank angeordneten Gleichrichter oder einen mit dem Stromrichter elektrisch verbundenen und in dem Stromrichterschrank angeordneten Einspeise-Rückspeise-Wechselrichter, der auch als Active Front End (AFE) bezeichnet wird, vor.

Durch einen Gleichrichter oder Einspeise-Rückspeise-Wechselrichter kann eine Netzfrequenz eines mit dem Stromrichter verbundenen Versorgungsnetzes vorteilhaft der Ausbildung der Stromrichtermodule angepasst werden. Ein Einspeise-Rückspeise-Wechselrichter ermöglicht außerdem vorteilhaft eine Rückspeisung von Energie, die von einer mit dem Stromrichter betriebenen Last, z.B. einem Motor, geliefert wird, in das Versorgungsnetz.

Eine weitere Ausgestaltung der Erfindung sieht einen mit den Modulzeilen verbundenen und in dem Stromrichterschrank angeordneten Bremssteller, der auch als Bremschopper bezeichnet wird, vor.

Durch einen Bremssteller kann vorteilhaft überschüssige Energie, insbesondere Energie, die nicht in ein Versorgungsnetz eingespeist werden kann, abgebaut werden.

Eine weitere Ausgestaltung der Erfindung sieht einen Anschlussschrank vor, der mit den Modulzeilen elektrisch verbundene Anschlüsse zur elektrischen Kontaktierung der Modulzeilen aufweist.

Ein derartiger Anschlussschrank hat den Vorteil, dass der Stromrichterschrank zum elektrischen Kontaktieren des Stromrichters, beispielsweise zum Anschließen von Kabeln, nicht geöffnet zu werden braucht. Dies erleichtert einerseits das elektrische Kontaktieren des Stromrichters und verhindert andererseits vorteilhaft eine Verschmutzung des Stromrichterschranks durch das Öffnen des Stromrichterschranks beim elektrischen Kontaktieren des Stromrichters.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines dreiphasigen Stromrichters,
- FIG 2: schematisch ein erstes Ausführungsbeispiel einer Stromrichteranordnung,
- FIG 3: schematisch ein zweites Ausführungsbeispiel einer Stromrichteranordnung,
- FIG 4: ein erstes Stromrichtermodul,
- FIG 5: zwei nebeneinander angeordnete erste Stromrichtermodule,
- FIG 6: eine erste Ansicht einer Zwischenkreisverschienung und daran angeordneter Phasenverschienungen, und
- FIG 7: eine zweite Ansicht einer Zwischenkreisverschienung und daran angeordneter Phasenverschienungen.

Einander entsprechende Teile sind in allen Figuren mit den gleichen Bezugszeichen versehen.

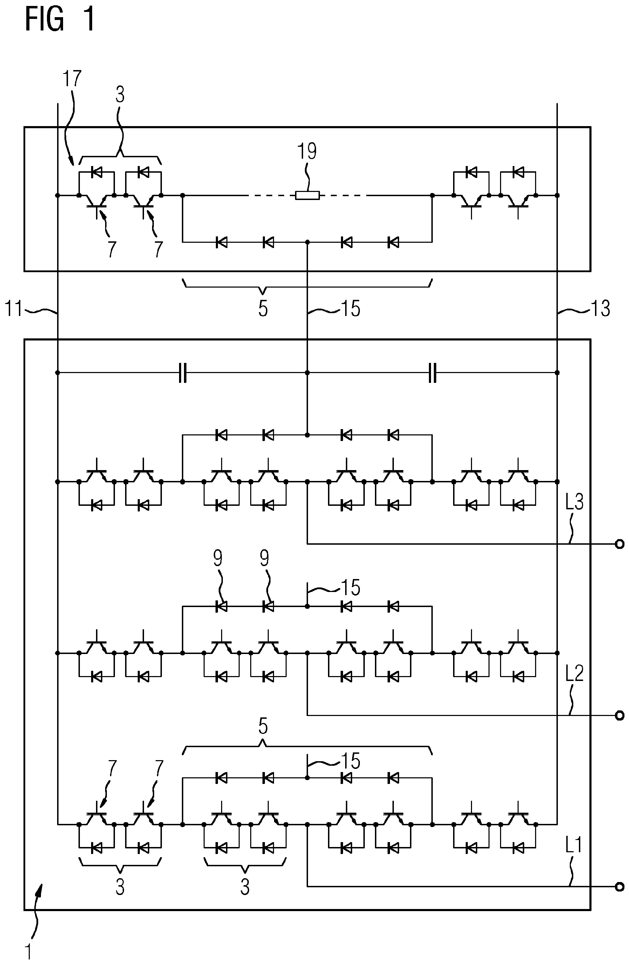

FIG 1 zeigt einen Schaltplan eines dreiphasigen Stromrichters 1. Der Stromrichter 1 ist als so genannter Dreipunkt-Wechselrichter in NPC-Topologie (NPC = Neutral Point Clamped) ausgeführt und weist für jede Stromrichterphase vier erste Stromrichtermodule 3, ein zweites Stromrichtermodul 5 und einen Außenleiter L1, L2, L3 auf. Jedes erste Stromrichtermodul 3 weist zwei erste Halbleiterbauelemente 7 auf, die zueinander elektrisch in Reihe geschaltet und jeweils als ein Bipolartransistor mit isolierter Gate-Elektrode (IGBT = Insulated-Gate Bipolar Transistor) ausgebildet sind. Jedes zweite Stromrichtermodul 5 weist vier zweite Halbleiterbauelemente 9 auf, die zueinander elektrisch in Reihe geschaltet und jeweils als eine Diode ausgebildet sind.

Die vier ersten Stromrichtermodule 3 jeder Stromrichterphase sind zueinander elektrisch in Reihe geschaltet. Das zweite Stromrichtermodul 5 der jeweiligen Stromrichterphase ist elektrisch parallel zu den beiden inneren ersten Stromrichtermodulen 3 dieser Reihenschaltung geschaltet. Ferner ist die Reihenschaltung der ersten Stromrichtermodule 3 zwischen deren beiden inneren ersten Stromrichtermodulen 3 mit dem Außenleiter L1, L2, L3 der jeweiligen Stromrichterphase elektrisch verbunden.

Jeweils eines der beiden äußeren ersten Stromrichtermodule 3 jeder Stromrichterphase ist mit einem ersten Zwischenkreisleiter 11 elektrisch verbunden. Das andere der beiden äußeren ersten Stromrichtermodule 3 jeder Stromrichterphase ist mit einem zweiten Zwischenkreisleiter 13 elektrisch verbunden. Das zweite Stromrichtermodul 5 jeder Stromrichterphase ist mit einem dritten Zwischenkreisleiter 15 verbunden. Der erste Zwischenkreisleiter 11 liegt auf einem ersten, beispielsweise positiven elektrischen Potential, der zweite Zwischenkreisleiter 13 liegt auf einem zweiten, beispielsweise negativen elektrischen Potential, und der dritte Zwischenkreisleiter 15 liegt auf einem dritten elektrischen Potential, beispielsweise einem Nullpotential.

In FIG 1 ist außerdem ein Bremssteller 17 dargestellt. Der Bremssteller 17 weist zwei erste Stromrichtermodule 3 auf, die jeweils wie die ersten Stromrichtermodule 3 der Stromrichterphasen ausgebildet sind und von denen eines mit dem ersten Zwischenkreisleiter 11 verbunden ist und das andere mit dem zweiten Zwischenkreisleiter 13 verbunden ist. Die beiden ersten Stromrichtermodule 3 des Bremsstellers 17 sind elektrisch in Reihe mit einem zwischen sie geschalteten Bremstellerwiderstand 19 geschaltet. Der Bremssteller 17 umfasst ferner ein zweites Stromrichtermodul 5, das wie die zweiten Stromrichtermodule 5 der Stromrichterphasen ausgebildet, elektrisch parallel zu dem Bremstellerwiderstand 19 geschaltet und mit dem dritten Zwischenkreisleiter 15 elektrisch verbunden ist.

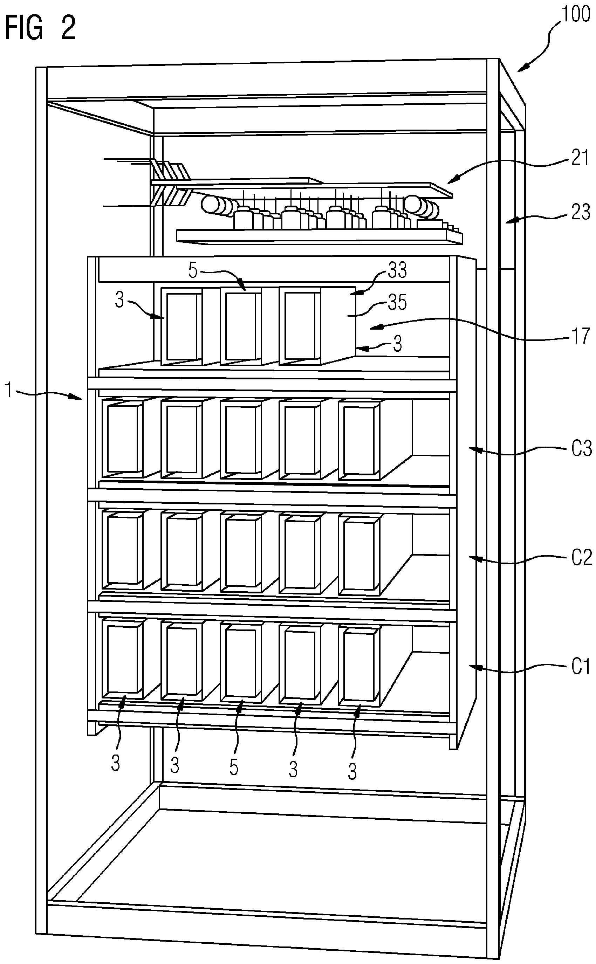

FIG 2 zeigt schematisch ein erstes Ausführungsbeispiel einer erfindungsgemäßen Stromrichteranordnung 100 in einer perspektivischen Darstellung, in der eine Frontseite der Stromrichteranordnung 100 sichtbar ist. Die Stromrichteranordnung 100 dieses Ausführungsbeispiels umfasst einen dreiphasigen Stromrichter 1, einen Bremssteller 17, einen Gleichrichter 21 und einen Stromrichterschrank 23, in dem der Stromrichter 1, der Bremssteller 17 und der Gleichrichter 21 angeordnet sind.

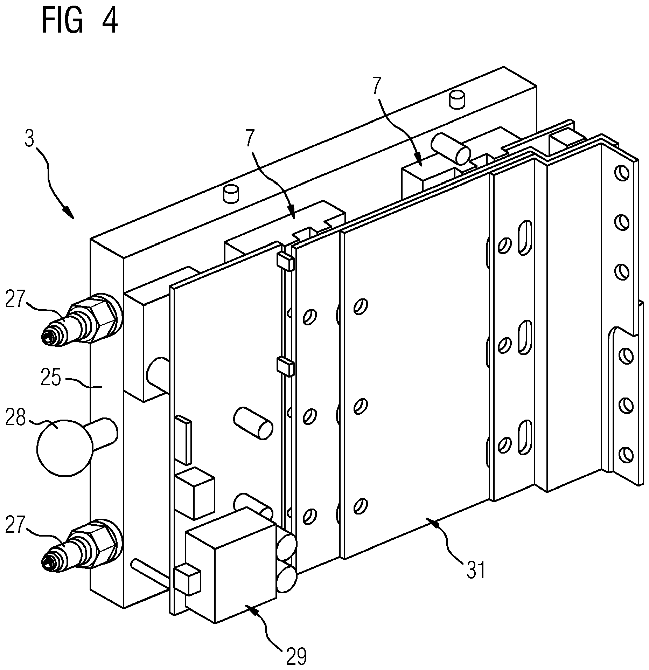

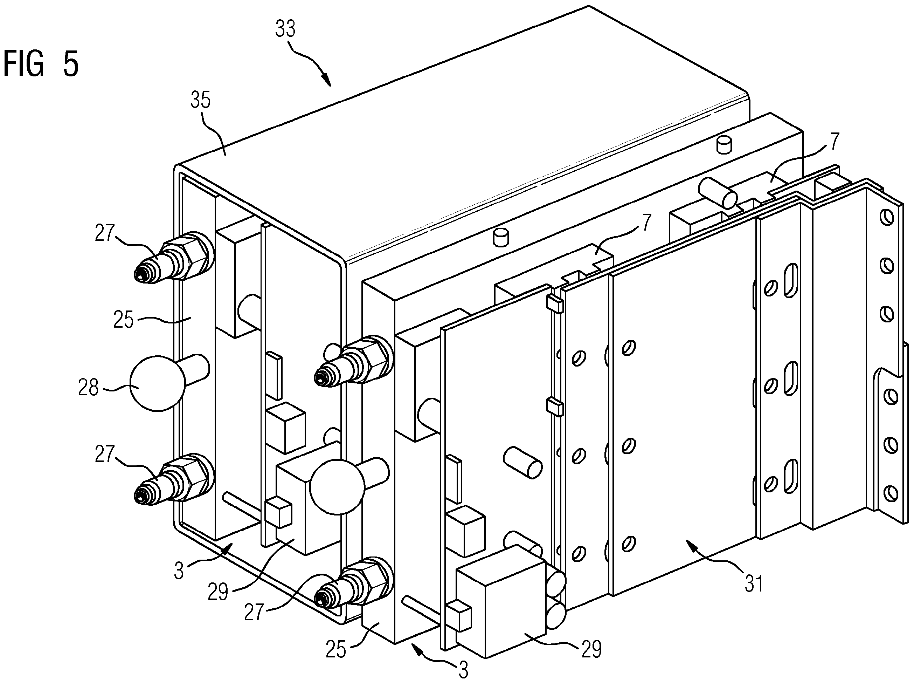

Der Stromrichter 1 und der Bremssteller 17 sind wie oben anhand der FIG 1 beschrieben ausgebildet und verschaltet. Dabei weist jedes Stromrichtermodul 3, 5 einen in FIG 2 nicht näher dargestellten Kühlkörper 25 auf, an dem die Halbleiterbauelemente 7, 9 des jeweiligen Stromrichtermoduls 3, 5 zu deren Kühlung angeordnet sind, siehe dazu FIG 4. Ferner ist jedes Stromrichtermodul 3, 5 in einer eigenen Stromrichterzelle 33 angeordnet, die ein Zellengehäuse 35 aus einem Polycarbonat oder Polymethylmethacrylat aufweist, siehe dazu auch FIG 5.

Die Stromrichtermodule 3, 5 sind derart in dem Stromrichterschrank 23 angeordnet, dass die Stromrichtermodule 3, 5 jeder Stromrichterphase eine Modulzeile C1, C2, C3 horizontal hintereinander angeordneter Stromrichtermodule 3, 5 bilden und die Modulzeilen C1, C2, C3 der verschiedenen Stromrichterphasen etagenweise übereinander angeordnet sind. Dabei ist das zweite Stromrichtermodul 5 jeweils als mittleres Stromrichtermodul 3, 5 der Modulzeile C1, C2, C3 angeordnet.

Der Bremssteller 17 ist in diesem Ausführungsbeispiel in einer separaten Etage des Stromrichterschranks 23 oberhalb der Stromrichtermodule 3, 5 der Stromrichterphasen angeordnet. Der Gleichrichter 21 ist in einer weiteren separaten Etage Stromrichterschranks 23 oberhalb des Bremsstellers 17 angeordnet.

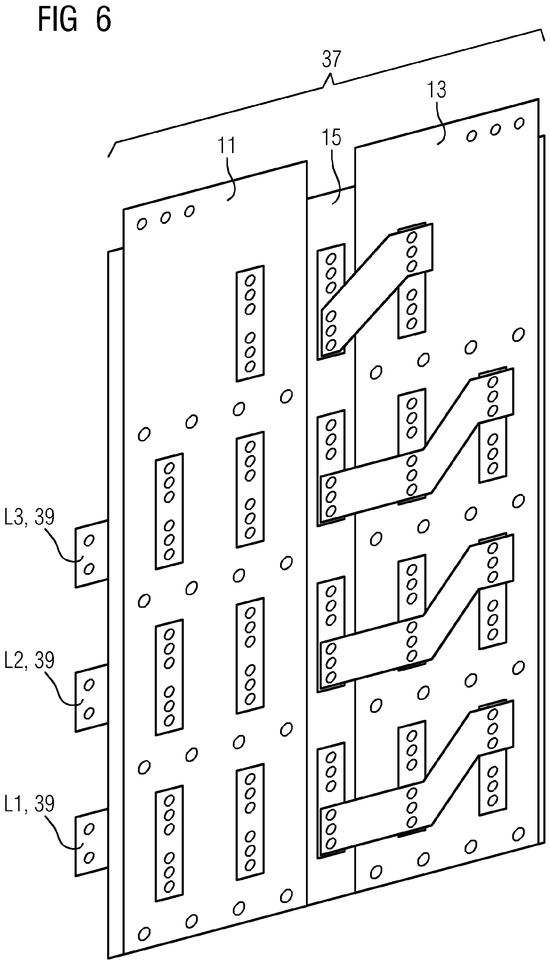

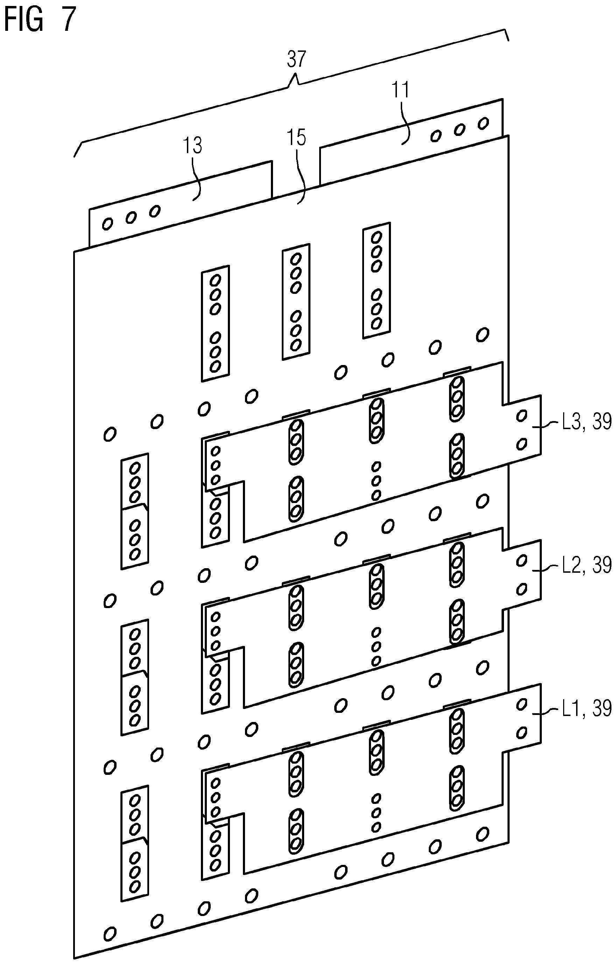

Die Zwischenkreisleiter 11, 13, 15 sind in Form einer an einer Rückseite der Stromrichteranordnung 100 angeordneten und daher in FIG 2 nicht sichtbaren vertikal verlaufenden Zwischenkreisverschienung 37 ausgeführt. Die Außenleiter L1, L2, L3 sind jeweils in Form einer ebenfalls an der Rückseite der Stromrichteranordnung 100 angeordneten und daher in FIG 2 nicht sichtbaren horizontal verlaufenden Phasenverschienung 39 ausgebildet, siehe dazu die Figuren 6 und 7. Zwischen den Stromrichtermodulen 3, 5 und den Verschienungen 37, 39 sind vorzugsweise Schutzplatten zum Schutz der Verschienungen 37, 39 angeordnet.

Der Gleichrichter 21 ist beispielsweise als ein zwölfpulsiger Gleichrichter ausgebildet.

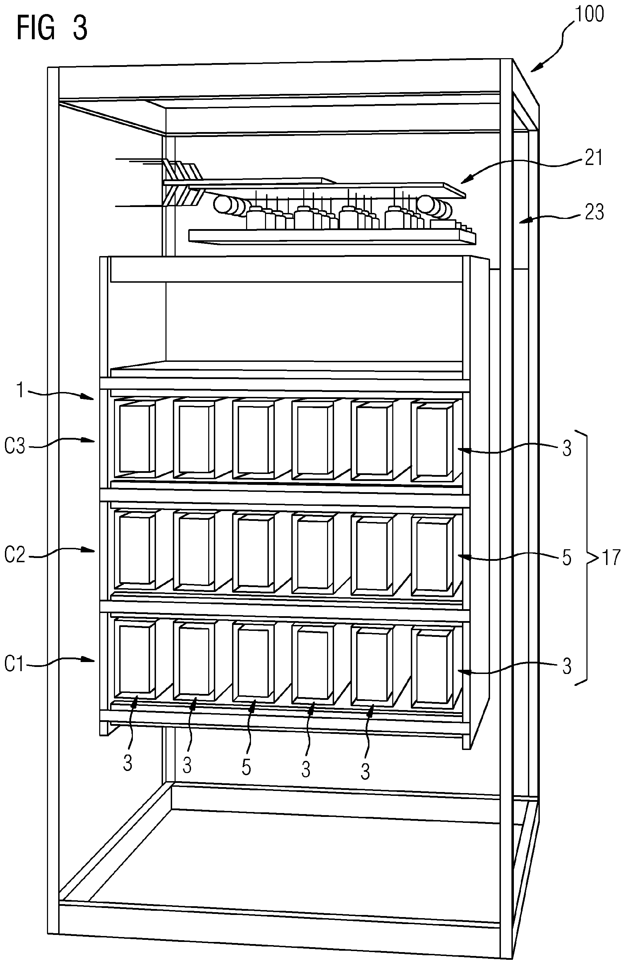

FIG 3 zeigt schematisch ein zweites Ausführungsbeispiel einer erfindungsgemäßen Stromrichteranordnung 100 in einer perspektivischen Darstellung. Dieses Ausführungsbeispiel unterscheidet sich von dem in FIG 2 dargestellten ersten Ausführungsbeispiel lediglich dadurch, dass die Stromrichtermodule 3, 5 nicht einer separaten Etage des Stromrichterschranks 23 angeordnet sind, sondern über die Etagen des Stromrichterschranks 23 verteilt sind, in denen die Stromrichtermodule 3, 5 der Stromrichterphasen angeordnet sind. Dabei sind die Stromrichtermodule 3, 5 des Bremsstellers 17 übereinander in jeweils einer anderen Etage des Stromrichterschranks 23 angeordnet und das zweite Stromrichtermodul 5 des Bremsstellers 17 ist zwischen den beiden ersten Stromrichtermodulen 3 des Bremsstellers 17 angeordnet.

FIG 4 zeigt ein erstes Stromrichtermodul 3 in einer perspektivischen Darstellung. Der Kühlkörper 25 ist im Wesentlichen quaderförmig zur Aufnahme einer Kühlflüssigkeit ausgebildet und weist zwei Kühlmittelanschlüsse 27 zum Zuführen und Abführen von Kühlflüssigkeit auf. Ferner ist an dem Kühlkörper 25 optional ein Handgriff 28 zur Vereinfachung des Einsetzens des Stromrichtermoduls 3 in eine Stromrichterzelle 33 und des Entnehmens des Stromrichtermoduls 3 aus der Stromrichterzelle 33 angeordnet. Die ersten Halbleiterbauelemente 7 sind an dem Kühlkörper 25 angeordnet. An einer von dem Kühlkörper 25 abgewandten Seite der ersten Halbleiterbauelemente 7 ist eine Ansteuerbaugruppe 29 angeordnet, über diese beiden Halbleiterbauelemente 7 ansteuerbar sind und die als eine mit entsprechenden elektronischen Bauelementen bestückte Ansteuerplatine ausgebildet ist. Ferner weist das erste Stromrichtermodul 3 eine Modulverschienung 31 auf, mittels derer es mit anderen Stromrichtermodulen 3, 5 und der Zwischenkreisverschienung 37 bzw. Phasenverschienung 39 elektrisch verbindbar ist.

FIG 5 zeigt eine perspektivische Darstellung zweier nebeneinander angeordneter erster Stromrichtermodule 3, die jeweils wie das in FIG 4 dargestellte erste Stromrichtermodul 3 ausgebildet sind. Dabei ist eines der Stromrichtermodule 3 innerhalb eines Zellengehäuses 35 dargestellt, während das andere ohne ein Zellengehäuse 35 dargestellt ist. Das Zellengehäuse 35 hat die Form eines offenen quaderförmigen Hohlzylinders, in den ein Stromrichtermodul 3, 5 einschiebbar ist.

Die Figuren 6 und 7 zeigen zwei sich gegenüber liegende Seiten einer Zwischenkreisverschienung 37 und dreier daran angeordneter Phasenverschienungen 39 in jeweils einer perspektivischen Darstellung. Die Zwischenkreisleiter 11, 13, 15 der Zwischenkreisverschienung 37 und die Phasenverschienungen 39 sind als planparallele elektrisch leitfähige Platten ausgebildet, wobei der erste Zwischenkreisleiter 11 und der zweite Zwischenkreisleiter 13 auf einer ersten Seite des dritten Zwischenkreisleiters 15 und die Phasenverschienungen 39 auf einer der ersten Seite gegenüber liegenden Seite des dritten Zwischenkreisleiters 15 verlaufen. Der erste Zwischenkreisleiter 11 und der zweite Zwischenkreisleiter 13 erstrecken sich in horizontaler Richtung voneinander beabstandet über voneinander verschiedene Abschnitte der horizontalen Ausdehnung des dritten Zwischenkreisleiters 15 und in vertikaler Richtung über die gesamte vertikale Ausdehnung des dritten Zwischenkreisleiters 15, wobei sie ein oberes Ende des dritten Zwischenkreisleiters 15 überragen. Die Phasenverschienungen 39 erstrecken sich vertikal voneinander beabstandet in horizontaler Richtung jeweils über einen Abschnitt der horizontalen Ausdehnung des dritten Zwischenkreisleiters 15 und überragen den dritten Zwischenkreisleiter 15 in horizontaler Richtung an einem seiner seitlichen Enden.

Eine Weitergestaltung der oben beschriebenen Ausführungsbeispiele sieht einen Anschlussschrank auf, der beispielsweise neben dem Stromrichterschrank 23 angeordnet ist. Der Anschlussschrank weist elektrische Anschlüsse auf, die mit in dem Stromrichterschrank 23 angeordneten elektrischen Komponenten zur elektrischen Kontaktierung dieser Komponenten, insbesondere zum Anschließen von Kabeln, elektrisch verbunden sind.

Alternative Ausführungsbeispiele sehen ferner statt eines Gleichrichters 21 einen Einspeise-Rückspeise-Wechselrichter (Active Front End) vor. Der Einspeise-Rückspeise-Wechselrichter umfasst beispielsweise für jede Stromrichterphase weitere Stromrichtermodule 3, 5, deren Anzahl und Ausbildung den oben beschriebenen Stromrichtermodulen 3, 5 der jeweiligen Stromrichterphase entsprechen und die in der derselben Etage des Stromrichterschranks 23 wie diese angeordnet werden, beispielsweise jeweils über einem entsprechenden Stromrichtermodul 3, 5 der oben beschriebenen Ausführungsbeispiele.

Weitere alternative Ausführungsbeispiele sehen anstelle von Kühlkörpern 25, die zur Aufnahme einer Kühlflüssigkeit ausgebildet sind, Kühlkörper 25 zur Luftkühlung der Stromrichtermodule 3, 5 vor. Derartige Kühlkörper 25 weisen vorzugsweise Kühlrippen zur Abgabe von Wärme an Luft auf.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Insbesondere ist die Erfindung nicht auf eine bestimmte Anzahl von Stromrichterphasen oder eine bestimmte Anzahl von Stromrichtermodulen 3, 5 je Stromrichterphase oder eine bestimmte Anzahlen von Halbleiterbauelementen 7, 9 der Stromrichtermodule 3, 5 beschränkt, sondern die oben beschriebenen Ausführungsbeispiele können in für den Fachmann offensichtlicher Weise anderen Anzahlen als die in diesen Ausführungsbeispielen genannten Anzahlen angepasst werden.

## Patentansprüche

1. Stromrichteranordnung (100) mit einem mehrphasigen Stromrichter (1), der für jede Stromrichterphase mehrere elektrisch miteinander verschaltete Stromrichtermodule (3,5) umfasst, und mit einem Stromrichterschrank (23), in dem der Stromrichter (1) angeordnet ist,
**dadurch gekennzeichnet, dass**
- jedes Stromrichtermodul (3,5) einen Kühlkörper (25) und wenigstens ein an dem Kühlkörper (25) angeordnetes Halbleiterbauelement (7,9) aufweist
- und die Stromrichtermodule (3,5) derart in dem Stromrichterschrank (23) angeordnet sind, dass die Stromrichtermodule (3,5) jeder Stromrichterphase eine Modulzeile (C1,C2,C3) horizontal hintereinander angeordneter Stromrichtermodule (3,5) bilden und die Modulzeilen (C1,C2,C3) der verschiedenen Stromrichterphasen vertikal übereinander angeordnet sind.

2. Stromrichteranordnung (100) nach Anspruch 1, **da-durch gekennzeichnet**, dass wenigstens ein Stromrichtermodul (3,5) in einer Stromrichterzelle (33) gekapselt ist.

3. Stromrichteranordnung (100) nach Anspruch 2, **da-durch gekennzeichnet**, dass wenigstens eine Stromrichterzelle (33) ein Zellengehäuse (35) aus einem Polycarbonat oder Polymethylmethacrylat aufweist.

4. Stromrichteranordnung (100) nach einem der vorhergehenden Ansprüche, **dadurch gekennzeichnet, dass** die Modulzeilen (C1,C2,C3) mit einer vertikal verlaufenden Zwischenkreisverschienung (37) elektrisch verbunden sind.

5. Stromrichteranordnung (100) nach einem der vorhergehenden Ansprüche, **dadurch gekennzeichnet, dass** die Stromrichtermodule (3,5) jeder Modulzeile (C1,C2, C3) mit einer horizontal verlaufenden Phasenverschienung (39) elektrisch verbunden sind.

6. Stromrichteranordnung (100) nach einem der vorhergehenden Ansprüche, **dadurch gekennzeichnet, dass** die Halbleiterbauelemente (7,9) der Stromrichtermodule (3,5) jeweils als ein Bipolartransistor mit isolierter Gate-Elektrode oder als eine Diode ausgebildet sind.

7. Stromrichteranordnung (100) nach Anspruch 6, **gekenn-zeichnet** durch wenigstens ein erstes Stromrichtermodul (3) mit genau zwei elektrisch parallel oder in Reihe zueinander geschalteten ersten Halbleiterbauelementen (7), die jeweils als ein Bipolartransistor mit isolierter Gate-Elektrode ausgebildet sind, und genau einer Ansteuerbaugruppe (29), über diese beiden ersten Halbleiterbauelemente (7) ansteuerbar sind.

8. Stromrichteranordnung (100) nach einem der vorhergehenden Ansprüche, **dadurch gekennzeichnet, dass** jede Modulzeile (C1,C2,C3) genau drei, vier oder fünf Stromrichtermodule (3,5) aufweist.

9. Stromrichteranordnung (100) nach einem der vorhergehenden Ansprüche, **gekennzeichnet durch** einen mit den Modulzeilen (C1,C2,C3) elektrisch verbundenen und in dem Stromrichterschrank (23) angeordneten Gleichrichter (21).

10. Stromrichteranordnung (100) nach einem der vorhergehenden Ansprüche, **gekennzeichnet durch** einen mit dem Stromrichter (1) elektrisch verbundenen und in dem Stromrichterschrank (23) angeordneten Einspeise-Rückspeise-Wechselrichter.

11. Stromrichteranordnung (100) nach einem der vorhergehenden Ansprüche, **gekennzeichnet durch** einen mit den Modulzeilen (C1,C2,C3) verbundenen und in dem Stromrichterschrank (23) angeordneten Bremssteller (17).

12. Stromrichteranordnung (100) nach einem der vorhergehenden Ansprüche, **gekennzeichnet durch** einen Anschlussschrank, der mit den Modulzeilen (C1, C2,C3) elektrisch verbundene Anschlüsse zur elektrischen Kontaktierung der Modulzeilen (C1,C2,C3) aufweist.

## Claims

1. Current converter arrangement (100) having a multi-phase current converter (1), which includes a number of current converter modules (3, 5) which are electrically connected to one another for each current converter phase, and having a current converter cabinet (23), in which the current converter (1) is arranged,
**characterised in that**
- each current converter module (3, 5) has a heat sink (25) and at least one semiconductor component (7, 9) arranged on the heat sink (25)
- and the current converter modules (3, 5) are arranged in the current converter cabinet (23) such that the current converter modules (3, 5) of each current converter phase form a module row (C1, C2, C3) of current converter modules (3, 5) arranged horizontally one behind the other and the module rows (C1, C2, C3) of the different current converter phases are arranged vertically one above the other.

2. Current converter arrangement (100) according to claim 1,
**characterised in that** at least one current converter module (3, 5) is encapsulated in a current converter cell (33).

3. Current converter arrangement (100) according to claim 2,
**characterised in that** at least one current converter cell (33) has a cell housing (35) made of polycarbonate or polymethyl methacrylate.

4. Current converter arrangement (100) according to one of the preceding claims, **characterised in that** the module rows (C1, C2, C3) are electrically connected to a DC link busbar (37) running vertically.

5. Current converter arrangement (100) according to one of the preceding claims, **characterised in that** the current converter modules (3, 5) of each module row (C1, C2, C3) are electrically connected to a horizontally running phase busbar (39).

6. Current converter arrangement (100) according to one of the preceding claims, **characterised in that** the semiconductor components (7, 9) of the current converter modules (3, 5) are each embodied as a bipolar transistor with an insulated gate electrode or as a diode.

7. Current converter arrangement (100) according to claim 6,
**characterised by** at least one first current converter module (3) with precisely two first semiconductor components (7) connected electrically in parallel or in series with one another, which are each embodied as a bipolar transistor with an insulated gate electrode, and precisely one control module (29), by way of which these two first semiconductor components (7) can be controlled.

8. Current converter arrangement (100) according to one of the preceding claims, **characterised in that** each module row (C1, C2, C3) has precisely three, four or five current converter modules (3, 5).

9. Current converter arrangement (100) according to one of the preceding claims, **characterised by** a rectifier (21) connected electrically to the module rows (C1, C2, C3) and arranged in the current converter cabinet (23).

10. Current converter arrangement (100) according to one of the preceding claims, **characterised by** feed-return inverter connected electrically to the current converter (1) and arranged in the current converter cabinet (23).

11. Current converter arrangement (100) according to one of the preceding claims, **characterised by** a braking chopper (17) connected to the module rows (C1, C2, C3) and arranged in the current converter cabinet (23).

12. Current converter arrangement (100) according to one of the preceding claims, **characterised by** a terminal cabinet, which has terminals connected electrically to the module rows (C1, C2, C3) for electrical contacting with the module rows (C1, C2, C3).

## Revendications

1. Agencement (100) de convertisseur de courant, comprenant un convertisseur (1) de courant polyphasé, qui comprend, pour chaque phase du convertisseur de courant, plusieurs modules (3, 5) de convertisseur de courant connectés électriquement entre eux et comprenant une armoire (23) de convertisseur de courant, dans laquelle le convertisseur (1) de courant est disposé,
**caractérisé en ce que**
- chaque module (3, 5) de convertissement de courant a un refroidisseur (25) et au moins un composant (7, 9) à semi-conducteur monté sur le refroidisseur (25)
- et les modules (3, 5) de convertisseur sont disposés dans l'armoire (23) de convertisseur, de manière à ce que les modules (3, 5) de convertisseur de courant de chaque phase du convertisseur de courant forment une ligne (C1, C2, C3) de modules (3, 5) de convertisseur de courant disposés les uns derrière les autres horizontalement et les lignes (C1, C2, C3) de modules des diverses phases de convertisseur de courant sont disposées en étant superposées verticalement.

2. Agencement (100) de convertisseur de courant suivant la revendication 1, **caractérisé en ce qu'**au moins un module (3, 5) de convertisseur de courant est encapsulé dans une cellule (33) de convertisseur de courant.

3. Agencement (100) de convertisseur de courant suivant la revendication 2, **caractérisé en ce qu'**au moins une cellule (33) de convertisseur de courant a un boîtier (35) en polycarbonate ou en poly (méthacrylate de méthyle).

4. Agencement (100) de convertisseur de courant suivant l'une des revendications précédentes, **caractérisé en ce que** les lignes (C1, C2, C3) de modules sont reliées électriquement à un rail (37) de circuit intermédiaire s'étendant verticalement.

5. Agencement (100) de convertisseur de courant suivant l'une des revendications précédentes, **caractérisé en ce que** les modules (3, 5) de convertisseur de courant de chaque ligne (C1, C2, C3) de modules sont reliés électriquement à un rail (39) de phase s'étendant horizontalement.

6. Agencement (100) de convertisseur de courant suivant l'une des revendications précédentes, **caractérisé en ce que** les composants (7, 9) à semi-conducteur des modules (3, 5) de convertisseur de courant sont constitués chacun sous la forme d'un transistor bipolaire à électrode de grille isolée ou sous la forme d'une diode.

7. Agencement (100) de convertisseur de courant suivant la revendication 6, **caractérisé par** au moins un premier module (3) de convertisseur de courant ayant exactement deux premiers composants (7) à semi-conducteur montés en parallèle ou en série l'un avec l'autre, ils sont constitués chacun sous la forme d'un transistor bipolaire à électrode de grille isolée et exactement un composant (29) de commande par lequel ces deux premiers composants (7) à semi-conducteur peuvent être commandés.

8. Agencement (100) de convertisseur de courant suivant l'une des revendications précédentes, **caractérisé en ce que** chaque ligne (C1, C2, C3) de modules a exactement trois, quatre ou cinq modules de convertisseur de courant.

9. Agencement (100) de convertisseur de courant suivant l'une des revendications précédentes, **caractérisé par** un redresseur (21) relié électriquement aux lignes (C1, C2, C3) de modules et monté dans l'armoire (23) de convertisseur de courant.

10. Agencement (100) de convertisseur de courant suivant l'une des revendications précédentes, **caractérisé par** arrivée-alimentation de retour montée dans l'armoire (23) de convertisseur (1) de courant.

11. Agencement (100) de convertisseur de courant suivant l'une des revendications précédentes, **caractérisé par** un actionneur (17) de frein relié aux lignes (C1, C2, C3) de modules et monté dans l'armoire (23) de convertisseur.

12. Agencement (100) de convertisseur de courant suivant l'une des revendications précédentes, **caractérisé par** une armoire de connexion, qui a des bornes reliées électriquement aux lignes (C1, C2, C3) de module pour la mise en contact électrique des lignes (C1, C2, C3) de modules.
